# EUROPEAN PATENT SPECIFICATION

(11) **EP 2 412 074 B1**
(45) Date of publication and mention of the grant of the patent: **12.11.2014**
(21) Application number: 10756805.7
(22) Date of filing: 24.03.2010
(51) Int. Cl.: H02J 13/00, H02J 7/35, H02H 7/10, G01R 31/42

(54) **SYSTEMS AND METHODS FOR PREDICTING POWER ELECTRONICS FAILURE**
SYSTEME UND VERFAHREN ZUR VORHERSAGE VON DEFEKTEN IN DER LEISTUNGSELEKTRONIK
SYSTÈMES ET PROCÉDÉS PERMETTANT DE PRÉDIRE UNE DÉFAILLANCE D'UN COMPOSANT ÉLECTRONIQUE

(30) Priority: 24.03.2009 US 211018 P
(43) Date of publication of application: 01.02.2012
(73) Proprietor: Infinirel Corporation, Frisco, Texas 75034 (US)
(72) Inventor: WANK, Norbert, Plano, Texas 75025 (US)
(74) Representative: Jansen, Cornelis Marinus
(86) International application number: PCT/US2010/028527
(87) International publication number: WO 2010/111412

(56) References cited:
- JP-A- 8 009 557
- JP-A- 8 181 343
- JP-A- 8 181 343
- JP-A- 9 084 371
- JP-A- 2001 095 263
- KR-A- 20090 002 295
- KR-A- 20090 002 295
- US-A1- 2002 085 397
- US-A1- 2008 285 317
- RISTOW A ET AL: "Development of a Methodology for Improving Photovoltaic Inverter Reliability", IEEE TRANSACTIONS ON INDUSTRIAL ELECTRONICS, IEEE SERVICE CENTER, PISCATAWAY, NJ, USA, vol. 55, no. 7, 1 July 2008 (2008-07-01), pages 2581-2592, XP011226601, ISSN: 0278-0046, DOI: 10.1109/TIE.2008.924017

## Description

### Field of Technology

The present disclosure relates to non-intrusively predicting power electronics failure. In some instances, the present disclosure is directed to methods, systems, and devices that utilize signal-processing to determine the substantial degradation of at least one internal component of a power converter circuit prior to it causing a system failure.

### Background

In today's efficiency-driven world, power electronics play a major role in the effort to enable a carbon-neutral footprint for transportation and energy production and transmission solutions. However, cost is critical for mass market adoption of residential and commercial solar power plants, electric vehicles, and industrial equipment, all of which are subject to high thermal stress, shock, and vibration, yet demand outstanding reliability and up-time. Therefore, the large majority of power conversion electronics rely on affordable aluminum electrolytic capacitors that have a poor track record of sustaining prolonged high temperatures. Electrolytic capacitors have been widely used as energy storage between, for example, solar panels and photovoltaic inverters.

Traditional on-board diagnostic systems have been customized to each inverter, typically monitoring proprietary error codes relating to over-temperature or over-current, for example. Third party performance monitoring systems have been used to alert operators of an actual inverter failure but have not been able to anticipate or predict impending failure. Mechanical-based systems have employed a condition-based maintenance concept, for example, performing acoustical vibration analysis to detect the early signs of an impending bearing failure or relying on modeling of operational parameters. Yet another approach to reliability-improvement is preventative maintenance. However, the preventative maintenance approach adds cost by necessarily increasing the number of service calls, increasing truck rolls, and placing additional strain on service personal on a more frequent basis.

In recent years improvements to inverter reliability have been made, but at the expense of individual component cost, such as the substitution of electrolytic capacitors with film capacitors and the substitution of insulated-gate bipolar transistors (IGBTs) with power junction gate field-effect transistors (JFETs). With increasing pressure on manufacturers to lower equipment costs to bring the cost of renewable energy in line with the cost of conventional energy, an increase in component cost is counter-productive to the goal of achieving grid-parity. Despite a theoretical improvement in reliability, external factors (such as poor inverter installation practice) put undue stress on electronic components resulting in accelerated material fatigue, temperature over-stress, and premature failure.

US 2002/0085397 A1 discloses detecting degradation in a smoothing capacitor of an inverter of a solar power generation system.

JP 8 181 343 discloses a long-term-deterioration prediction method of a link inverter of a solar energy power generation system for houses.

In view of the foregoing, there remains a need for devices, systems, and methods for non-intrusively predicting power electronics failure, especially in the context of power inverters utilized in solar panel fields.

### SUMMARY

The present disclosure provides a system as disclosed in claim 9, and a method as disclosed in claim 1 of utilizing signal-processing techniques to detect at least one degrading component of a power conversion unit located in an energy generation or storage unit. The systems, devices, and methods of the present disclosure are applicable to a wide range of energy generation and energy storage units, from commercial power plants to residential solar applications to electric vehicles. As will be understood by those skilled in the art, the systems, devices, and methods of the present disclosure are suitable for use with any electronics system that includes energy generation, energy storage, and/or energy conversion.

Some embodiments of the present disclosure operate with a central database and application server ("server") and at least one sensor master unit ("master") per plant. In some instances, each plant includes at least two masters (the second master acting as a back-up or redundancy in the event of a failure of the first master) and a plurality of slave sensor units ("slaves") in communication with the master(s) via powerline or wireless interfaces. At least the master is in communication with a database that includes an application server, a source data warehouse, and a customer database server. In some instances, the database is remote from the plant where the master and slaves are located. Signal processing tasks performed among the localized sensor units (master and slaves) and the database can be dynamically adjusted (e.g., partitioned), so that certain signal processing tasks are performed at the database/server level to allow for sufficient feature growth and local processing power at the slave and master nodes. Such dynamic adjustment is implemented in some embodiments by field-programmability-over-the-air (FOTA).

In some embodiments, each slave independently monitors input and output voltages, input and output currents, ambient temperature, and internal temperature for each inverter it is connected to. Generally, the slave is connected to the inverter(s) by attachment to the inverter's terminal clamps and service panel access. Accordingly, the slaves may be connected to virtually any inverter, regardless of manufacture.

The master and slaves are in communication with one another via either a wired or wireless connection. While numerous hardwired interfaces are suitable between the master and slaves, such as RS-485, CAN, or MODbus, often the wired interface will be through the already inter-connected power lines. Because the inverters are connected together on the low-voltage side of the upstream distribution transformer, good bandwidth can be obtained with little interference from a broadband-over-powerline ("BPL") implementation. Due to the relative short distance between inverters installed in the same solar park, a Zigbee wireless network can also provide a well-accepted intra-plant communication channel between the master(s) and the slaves. Arbitration, under control of the database/server, is implemented in the event that the first master fails and the second master assumes the role of the first or primary master, consolidating plant performance data, data compression, encryption, and transportation of bundled data to the database/server via WAN services, such as DSL, T1/E1, Ethernet, GSM/GPRS, CDMA, or satellite communication. In some embodiments, the master includes slave functionality of measuring inverter performance. The data-acquisition employs at least two high-speed current measurement and signal-conditioning devices for input and output current in some instances.

In some embodiments, the master is adapted to receive new or updated characterization data to determine at least one failure parameter. Examples of failure parameters includes time derivatives, changes, of operating frequencies, equivalent static resistance ("ESR"), harmonic frequency balance, etc. For example, a slave operating in accordance with one embodiment of the present invention utilizes the newly acquired or updated parametric data, or a portion thereof (e.g., ESR data), to generate a more accurate prediction of failure (Estimated-Time-To-Failure, or "ETTF"), based on similar models deployed already in the field. Such parametric updates are obtained using Field-programmability-Over-The-Air, ("FOTA") techniques in some instances.

Further, redundancy is built into each major operating block of the invention: each slave and master unit have dual core processing, partitioned between a digital signal processing ("DSP") and conventional micro-controller core, each processor core has its individual watchdog that is cross-linked to the other processor. In other words, the DSP can take control of the microcontroller if its watchdog times-out, and vice versa, the micro-controller can take control of the DSP if its watchdog times out, and take control of the multi-channel bi-directional serial port ("MCBSP") to inform the server of the recoverable failure condition via the WAN. The watchdogs have independent timing constants in some instances. In some instances the database/server operates a mirror site, geographically separated, replicating all information between Application Server, Source Data Warehouse, and Customer Database. A "Last Known Good Code" is kept safely in a separate Boot image, which allows the system to revert back to a known good state in case the FOTA procedure was not executed successfully. Generally, protected data tunneling techniques (e.g., encryption, such as SAS-70 Type II) are utilized for communications between the master and the database/server, between the database/server and its mirror image, and between the database/server and remote terminals.

A more complete understanding of the system and method of utilizing signal-processing techniques to detect at least one degrading component of a power conversion unit will be afforded to those skilled in the art, as well as a realization of additional advantages and objects thereof, by a consideration of the following detailed description of the embodiments illustrated in the appended sheets of drawings.

### BRIEF DESCRIPTION OF THE DRAWINGS

FIG. 1 is a diagrammatic schematic of a prior art performance monitoring system.
FIG. 2 is a diagrammatic schematic of a predictive monitoring system in a single plant environment in accordance with one embodiment of the present disclosure.
FIG. 3 is a diagrammatic schematic of a predictive monitoring system in a multi-plant environment in accordance with one embodiment of the present disclosure.
FIG. 4 is a diagrammatic schematic of master and slave circuit architecture in accordance with one embodiment of the present disclosure.
FIG 5. is a flow chart illustrating a method of monitoring an inverter with a performance monitoring system in accordance with one embodiment of the present disclosure.
FIG. 6 is a diagrammatic schematic of a predictive monitoring system integrated into a power converter that is connected in a network of distributed power converters in accordance with another embodiment of the present disclosure.

### DETAILED DESCRIPTION

The present invention provides systems, devices, and methods of utilizing signal-processing to predict at least one substantially degraded electrical component inside a power conversion unit, such as a photovoltaic inverter. In the detailed description that follows, like element numerals are used to describe like elements illustrated in one or more figures.

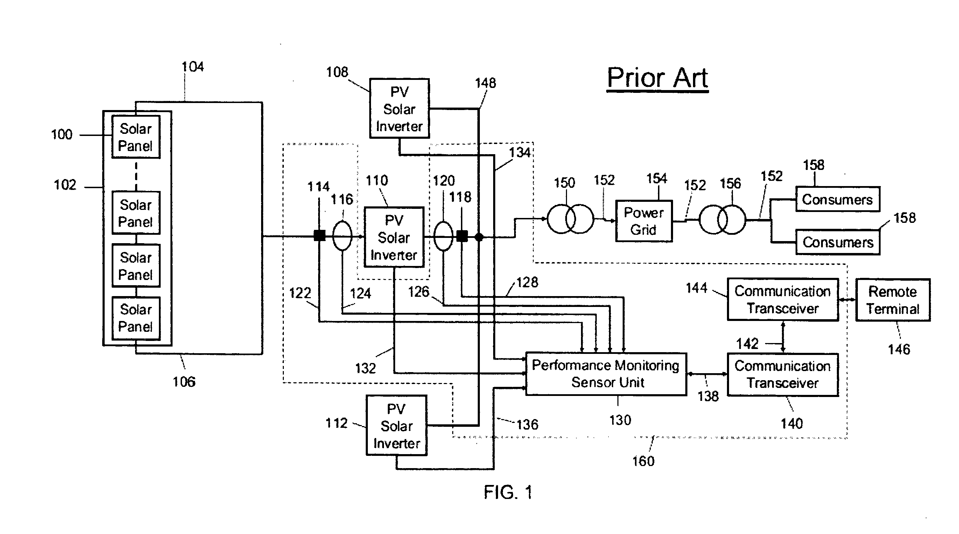

FIG. 1 illustrates a prior art performance monitoring system 160 where a performance monitoring sensor unit ("monitor") 130 communicates with a plurality of photovoltaic solar inverters (i.e., 108, 110, 112), also referred to as PV inverters, which can be of the same kind or of different manufacture, brand, make or model, via a plurality of proprietary digital interfaces (i.e., 132, 134 and 136 ). The monitor 130 also communicates with a plurality of external circuits (i.e. 114, 116, 118, 120), including a voltage sensor 114 and a current sensor 116 that are connected to the inverter input, and a voltage sensor 118 and a current sensor 120 that are connected to the inverter output. Each sensor output is connected to the monitoring unit using either an analog or a digital connection (i.e., 122, 124, 126, 128). The external circuits generally include means for monitoring current, voltage, and temperature, and the output connections generally include analog 4-20mA, analog voltage, digital 1-Wire(TM), 2-Wire(TM), SPI(TM), 3-Wire interface, or other serial digital communication interfaces. The monitor 130 communicates to a transceiver 140 via a communication interface 138, most commonly through a serial port. The transceiver 140 uses tethered (i.e. Ethernet, DSL) or untethered (i.e. GSM, GPRS, CDMA) communication means 142 to communicate with at least one other transceiver 144 that displays the information at a remote terminal 146, such as a computer screen or handheld terminal. Generally, alternating current produced from each inverter is commonly synchronized and combined via at least one power line 148 at a up-transformer 150 that connects, via a plurality of power transmission lines 152, into a utility power grid 154, which connects to a down-transformer 156 to a plurality of power consumers 158.

As shown in FIG. 1, the sensor 130 monitors the output voltage and current of each inverter 108, 110,112 by sampling the respective output connections to power line 148, and also monitors the inverter input from DC link lines 104, 106 with an analog-to-digital converter inside the monitor that is connected to the input voltage and current sensors 114, 116, which are connected to at least one string 102. String 102 is a series connection of a plurality of solar panels 100. Multiple strings may be connected in parallel to reach the desired input power to the inverter. Depending on the desired power capacity of the solar array, at least one string is connected to each inverter input, but not shared with multiple inverters. The sensor 130 reads error codes from each inverter 108, 110, 112 via a proprietary protocol over the interfaces 132, 134, 136. A malfunctioning inverter may send an error code to the monitor informing it about the outage.

The problem with prior performance monitoring systems, such as the one illustrated in Fig. 1, is that they do not prevent a failure from occurring, but instead add complexity and expense to a power generation plants, especially in the context of a portfolio of distributed power generation plants, by requiring each monitor 130 to communicate with multiple brands of inverters over proprietary communication interfaces in order to inform the operators of the distributed power generation plant of a failure that has already occurred. Not only does this require the monitor to be specifically programmed or configured for each different type of inverter it is connected to, this also requires the operator to dispatch a service call to investigate the failure and, potentially, a second truck roll to replace the malfunctioning equipment. During this time the plant is incurring a loss of power generation capacity and revenue. It also requires close proximity of all inverters to the monitor in order avoid additional cost of long cable runs from the monitor to each inverter, which is not practical in large power plants.

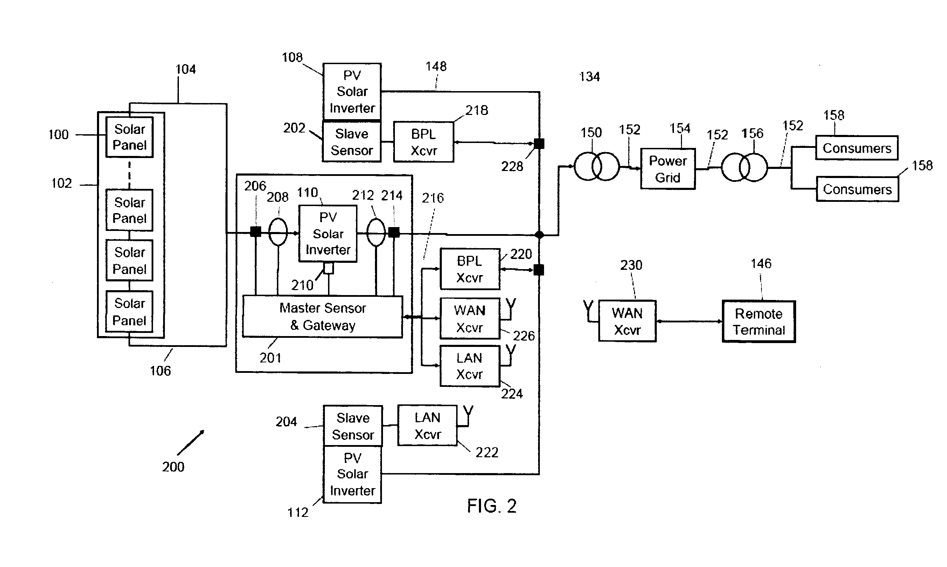

FIG. 2 illustrates a predictive monitoring system 200 operating in accordance with one embodiment of the present invention. Specifically, a master sensor and gateway ("master") 201 is used to communicate with a plurality of slave sensors ("slaves") (i.e., 202 , 204) via a broadband-over-powerline ("BPL") connection or other Local Area Network ("LAN") connection. In the illustrated embodiment, BPL transceivers 218, 220 and power-line signal couplers 228 are utilized. In one embodiment of the present disclosure, the LAN utilizes wireless communication standards such as 802.11, commonly known as WiFi, or 802.15, commonly known as Zigbee. In another embodiment, the LAN utilizes tethered communication means, such as Ethernet or RS-485 interfaces. In the illustrated embodiment, the master 201 is in communication with a LAN transceiver 224 that may include such wired or wireless features to communicate with a LAN transceiver 222 associated with the slaves. The master 201 further uses a Wide-Area Network ("WAN") interface 226 to backhaul data acquired through any other master and/or slave sensor to a remote WAN receiver 230 that interfaces to a remote terminal unit 146. The master 201 communicates with the transceivers 220, 224, 226 through a multi-channel bi-directional serial port ("MCBSP") 216. As shown, the systems, devices, and methods of the present disclosure utilize the existing infrastructure of power input from a solar array, consisting of at least one string 102, on the production side and also utilize the existing infrastructure of the power distribution system (i.e., 150, 152, 154, 156, 158) on the storage/consumption side.

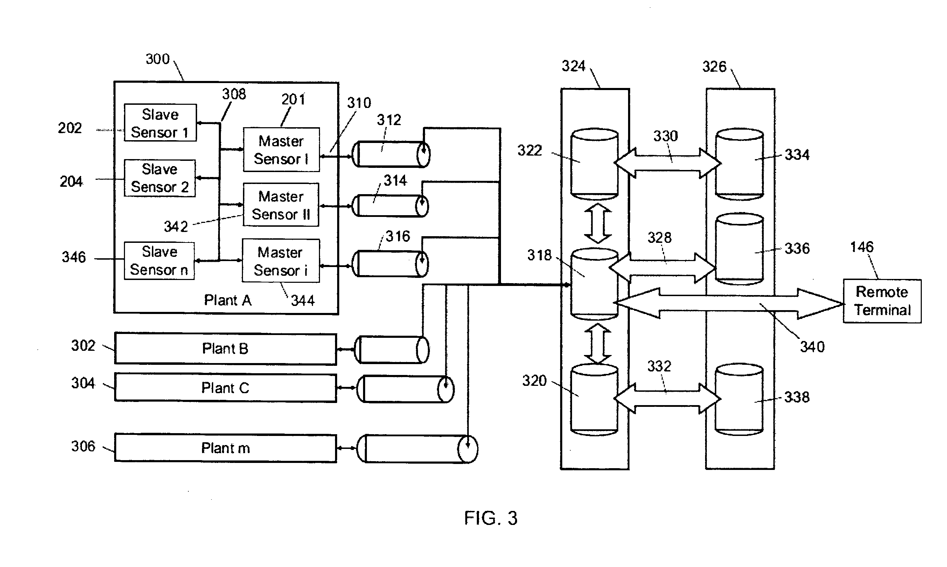

FIG 3. illustrates one implementation of the concepts of the present disclosure in the context of a plurality of distributed power generation plants (300, 302, 304, 306). Each plant 302, 304, 306, 308 has a plurality of slave sensors (e.g., 202, 204, ..., 346), connected via LAN 308 to at least one master sensor 201. The master sensor 201 has the same sensing capabilities as the slave sensors, but includes greater processing power to accommodate the additional data traffic from the plurality of slave sensors. Further, the master sensor 201 includes at least one WAN port to communicate to a central database 324. Accordingly, each inverter within a plant will have a slave sensor (or possibly the master 201, if the master is associated with that inverter) attached at its input and output. For example, in the illustrated embodiment of Fig. 2, inverter 110 is associated with master 201, while inverters 108 and 112 are associated each slaves 202 and 204, respectively.

Referring again to Fig. 3, at any given time generally only one Master controls extra-plant data traffic through a WAN interface 310 via a secure data tunnel 312 to the central database 324. In another embodiment, however, one or more auxiliary or backup masters 342, 344 secure a separate data port 314, 316 to the application server 318 that is part of the central database 324. While an auxilliary port is not being used for actual data transmission until a master 201 with higher priority fails and the application server switches to master 342 or master 344, previously operating in stand-by mode, it can be derived that this redundancy can be expanded to N+i, with i being the total number of masters per plant. A similar approach is taken with applying a redundant or backup cluster 326 to the operating database 324. Following the dimension model to support scalability and high intrusion resistance, each database is constructed out of at least three independently operating database servers. In the illustrated embodiment, the central database 324 includes: an application server 318, a source database 320, and a customer report database 322. Generally, the application server 318 parses incoming data into the source database 320 and/or customer report database 322, and also runs post-processing algorithms, such as pattern recognition, trending, and data correllation. In one embodiment, each server operates as a cluster, having at least one duplicate image or backup cluster 326. The backup cluster 326 includes a backup application server 336, a backup source database 338, and a backup customer database 334. The backup cluster 326 may be created locally (relative to database 324) and/or may be operated off-site in a different geographical region. Secure communication links 328, 330, 332 connect the databases of the backup cluster 326 to the respective databases of the central database 324.

In some embodiments the datasets sent to the database 324 consists of a time series of voltage, current, and temperature values that have been reduced to a multitude of calculated statistical metrics, such as peak, mean average, and first derivative calculations with time as the denominator. A first derivate indicates a trend. Accordingly, the derivatives of these metrics can be utilized to follow trends of the inverter. Typically, the greater the change that occurs in a given time period, the closer the device, whose parameter is being tracked via its derivative, is to approaching its wear-out limit. The first derivative can be described as a non-linear function with a multitude of input variables determining component performance. Generally, any data obtained from the master and slave sensors of a plant can be analyzed to identify trends associated with device failure. Accordingly, the systems, devices, and methods of the present disclosure enable an active learning process, which uses pre-failure performance data stored collectively at the central database, to indicate the statistical likelihood of a failure as a function of the derivative. For example, as capacitor ESR increases exponentially over time, normalized to the same operating conditions (e.g., temperature, average current, input voltage) as initially recorded as baseline data, the rate of change in ESR is indicative of how close to an actual failure the component is. Based on previously recorded failures with similar devices in the field this determination can be accurately predicted and updated over time based on the data received from other similar devices in the field. Analysis of rate-of-change, also called first derivative, can be applied to various component performance indicators to accurately analyze components such as power switches, including power MOSFETs, IGBTs, p-JFETs, controller boards, diodes. These component indicators include, but are not limited to leakage current, cross-conduction, rise- and fall-times, response time, and signal propagation delay.

The application server 318 pulls data from the customer report database 322 and submits it via an application programming interface ("API") to a remote terminal 146 at the client site. The remote terminal 146 is configured for receiving the alert notification, viewing the trend data, and receiving predictive failure information, such as estimated-time-to-failure and confidence level. The remote terminal is generally any suitable computing device for receiving communication from the server, database, or master sensor. For example, in some instances the remote terminal is a personal computer (e.g., desktop, laptop, netbook), handheld device (e.g., cell phone, PDA), or other suitable device.

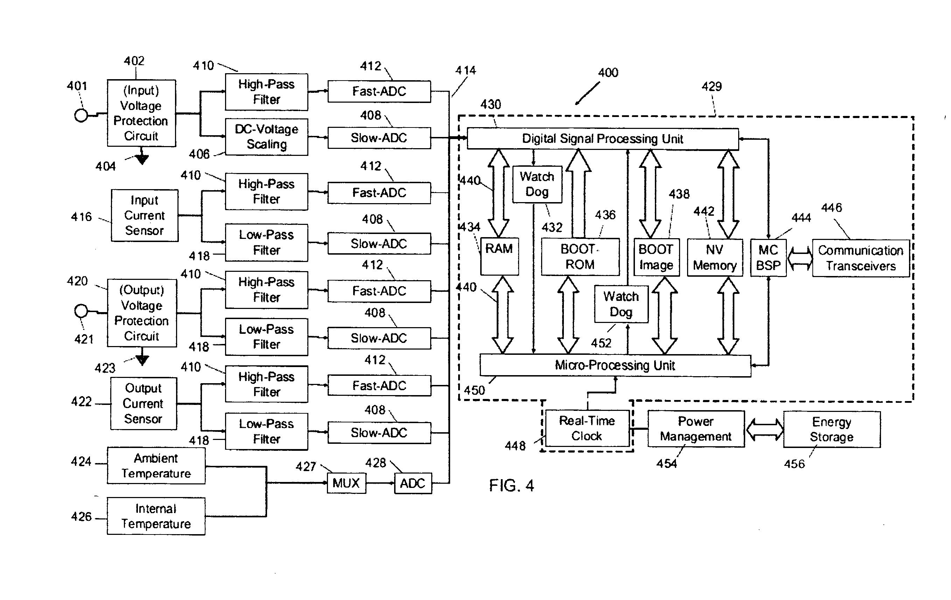

FIG. 4 illustrates a general circuit architecture 400 utilized for some embodiments of the present disclosure. As shown, the circuit architecture 400 includes an input protection circuit 402 associated with a voltage input 401 and an output protection circuit 420 associated with a output-voltage input 421. The input and output protection circuits 402, 420 each include lightning arrestors and over-voltage clamps that are known to those of skill in the art. As shown, the input protection circuit 402 is connected to ground 404, while output protection circuit 420 is connected to ground 423. The circuit architecture 400 further includes an input current sensor 416, an output current sensor 422, at least one internal temperature sensor 426, an ambient temperature sensor 424, a plurality of high-pass filters 410 and low-pass filters 418, a plurality of high-speed analog-digital converters 412, a plurality of low-speed analog-digital converters 408, a signal-processing and communication unit 429, a power management unit 454, and an energy storage unit 456. The temperature sensors 424, 426 are connected to the signal-processing and communication unit 429 via multiplexer 427 and analog-to-digital converter 428. As shown, the signal-processing and communication unit 429 includes a digital signal processor 430 with its associated watch dog 432 and a micro-processing unit 450 with its associated watch dog 452. Each of the processing units 430, 450 are in communication with RAM 434, boot ROM 436, boot image 438, non-volatile memory 442 and MCBSP 444. As shown the MCBSP 444 is in communication with one or more communication transceivers 446 (such as transceivers 220, 222, 224, and/or 226 of Fig. 2). The processing and communication unit 429 also includes a real-time clock 448.

In order to provide high reliability, signal processing is performed by the DSP (430) and communication tasks are performed by the micro-processor 450. Both processing units have an interlocked watchdog 432, 452, respectively, so that the DSP can take control of the communication port 444 when the micro-processor is non-responsive and requires a reboot, and vice versa, the micro-controller can reboot the DSP when it becomes non-responsive. Because each master and slave is field-programmable over-the-air (FOTA), an image of the previously working BOOT RAM is stored order to keep the spirit of high system reliability. If one processor is not booting with the new uploaded code, the other processor can issue a reset and point the memory index to the previously known-as-good code.

One can appreciate the fact that both master and slave units share the same general circuit architecture 400 in some instances. However, in some embodiments the master utilizes processors 430 and 450 with much greater processing and I/O capabilities relative to corresponding processing units of a slave. Further, the master typically includes a communication transceiver that is equipped with at least one WAN transceiver (as shown in greater detail on FIG. 2) that is not necessarily included in the slave. In other embodiments, the master and slaves have identical circuit architectures such that the master(s) are designated by providing master-level authority to particular devices either through hardware (e.g., a switch) or software designations.

Relative to the redundancy features discussed above, generally master units have the ability to arbitrate priority and act as a fail-over switch, assuming control if the next higher priority master has failed to either process data via DSP 430 or communicate via micro-processor 450 to the central database. In the event of a slave processor failure, the remaining processor communicates its work load through MCBSP 444 to the associated master, which then decides which slave has sufficient processing bandwidth to assume the task of the failed sensor node, or if a back-up master in the same plant can assume the signal processor role for the malfunctioning slave. This process is commonly known as virtualization.

In one embodiment, the slave sensor unit communicates via transceiver 446 through a Local Area Network (LAN) to at least one master sensor and gateway within the plant. In another embodiment, and in addition to the LAN connectivity of the slave sensor unit, the master sensor includes means to communicate data via a Wide-Area Network (WAN) transceiver. Such network connection may include tethered means of communication such as Ethernet or DSL, or wireless connections such as GSM, GPRS, CDMA or WiMAX. Because communication technology evolves over the operating life of the plant, it should be appreciated that any future communications module can be connected to the master or slave via a multi-channel bi-directional serial port (MCBSP) or other suitable connection. It should further be appreciated that all PV inverter outputs are already connected via powerline, and thus a preferred communication means in some instances is through a power-line modem or broadband-over-powerline (BPL). Such an arrangement avoids the additional cost for cables and installation associated with other LANs, while offering a solid connection and protected data path not necessarily afforded by a wireless connection. In that regard, referring again to Fig. 2, slave sensor 202 communicates via BPL transceiver 218, connected through a coupler 228 to power-line 148 to a receiving BPL transceiver 220 at the master sensor 201. Further, slave sensor 204 uses a wireless LAN transceiver 222, which follows at least one wireless standard such as 802.11, generally known as WiFi, or 802.15, generally known as Zigbee, to communicate data derived from the operation of PV inverter 112 via a receiving LAN transceiver 224 that is attached via a multi-channel bi-directional serial port 216 to at least one master sensor 201.

Referring to Figs. 2 and 4, general operation of the circuit architecture 400 will be described. Input current sensor 416 takes high-speed data samples (at least 14-bit, but preferably at least 16-bit) at a high resolution (at least 250kHz, but preferably at least 1 MHz) of the input current flowing from the string 102 through DC link wires 104 and 106 into inverter 110, where it recharges at least one capacitor inside the inverter commonly referred to as "DC link" capacitor. Traditionally, this capacitor of electrolytic type, and technical literature has described that this component fails due to elevated temperature exposure and high absolute temperatures that cause the electrolyte to evaporate. This, in turn, lowers the capacitor's ability to store energy (also referred to as its capacitance) and its internal resistance to current flow (commonly defined as Equivalent Series Resistance ("ESR")). Higher resistance results in more heat being dissipated internally, which raises the capacitor's internal temperature, accelerating the electrolyte evaporation. This cycle repeats itself until the ripple voltage produced by the charge and discharge currents flowing through the ESR is so great that the inverter operates outside of its nominal specifications and shuts-off. In some cases, the capacitors degraded ability to store energy puts undue stress on the power switching elements of the inverter, causing it to fail. Self-heating may also become excessive so that a fire may result. The present disclosure provides non-intrusive and manufacturer-agnostic systems, devices, and methods to detect degrading inverter components prior to failure, so that operators can plan for an orderly shut-down and scheduled replacement of the inverter or inverter subsystem.

A second input, utilizing output current sensor 422, samples inverter output currents approximately in-sync to the input current, detecting the main switching frequency of the inverter and its harmonics through common signal processing techniques, such as Fast-Fourier Transformation ("FFT"). The present disclosure relies on the ability of the master sensor and slave sensor to obtain sufficient details of the inverter performance, on the basis of time and amplitude resolution, that small increments of change, on the order of 0.01% per day or less in some instances, can be tracked. In that regard, the master and/or central server 324 perform derivative calculations, such as the change of an operating parameter over time, temperature, input current, and/or output current, can be correlated with the operating parameters of other inverter units monitored within a global network of distributed generation plants that are all connected to the central server.

As depicted in Fig. 4, each input signal is divided into high-pass and low-pass signal processing paths. By separating the 50Hz or 60Hz power grid frequency signal from the range of common switching frequencies, typically above 6kHz, maximum signal-to-noise ratios ("SNR") can be obtained, maximizing the resolution of the analog-digital converter ("ADC"). In one embodiment, eight ADCs with a resolution of 16-bit and 1.25MHz sample rate have been used. However, cost-performance trade-off may allow different ADCs, as long as the effective number of bits exceeds 12 bits and the sample rate is at least eight times larger than the maximum switching frequency expected from the network of inverters.

In addition to the current measurements, voltage samples are taken from the input and output of the inverter. The current data is likewise split into high-pass and low-pass signal processing paths. The synchronous sampling of 50/60-Hz output information allows the determination of power factor and is one metric considered for the health of the inverter system. For example, the loss of the inverter's ability to correct for power factor can cause substantial heating on the power switches employed in the inverter, and bear reason for concern.

Additionally, two temperature channels are sampled to obtain a differential between the ambient temperature and the internal power stage temperature of the inverter. These measurements provide an indication of the inverter's ability to dissipate internally generated power losses and/or an indication of degradation in inverter efficiency. Internal temperature measurement is also required to compensate for the change in ESR, for example, that is caused by temperature in order to reduce the possibility of false alerts.

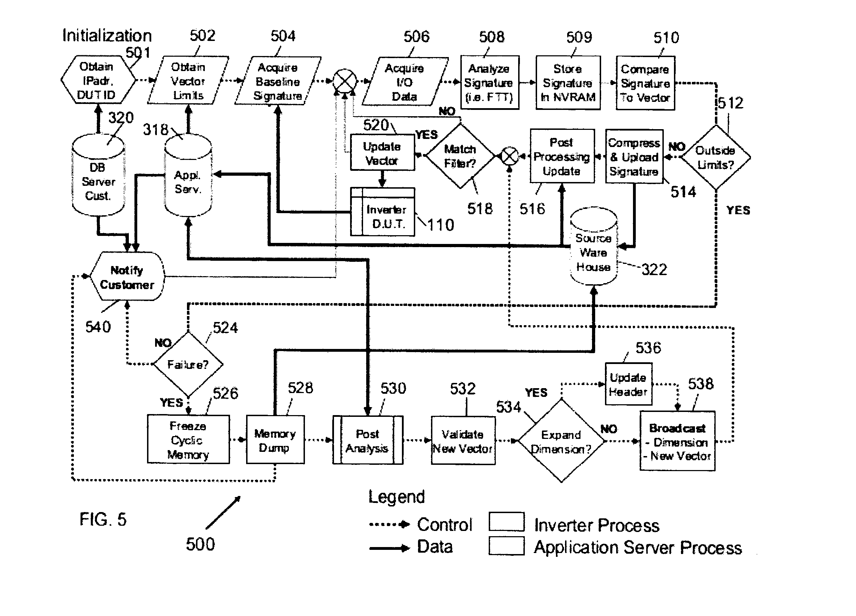

Referring now to FIG. 5, shown therein is a method 500 for predicting failure and adaptive learning of additional failure indicators during the course of operation of a power plant in accordance with the concepts of the present disclosure. As discussed above, the method 500 utilizes three separate servers for executing applications on the application server 318, performance and failure data stored on the source ware house server 322, and customer and report data stored on the customer server 320. However, it is understood that these three servers are combined into a single server or database in some embodiments. The method 500 begins at step 501 with an initialization, where the master's MAC address is associated to an IP address assigned by the application server. Similarly, during the initialization each slave will be assigned an internal IP address through the master that is associated with each slave's MAC address. Based on model type and serial number of the inverter associated with each slave, a default set of threshold and performance limits are downloaded from the application server to the master at step 502. These default limits are utilized in subsequent steps of the method 500 to determine whether the condition of the inverter as monitored by the sensors requires initiation of a client-determined alert trigger.

At step 504, a 24-hour assessment of the inverter's characteristic data at various operating conditions is performed to create an expandable, multi-dimensional matrix of dataset points. For example, the chart below provides exemplary operating conditions that are utilized in some instances to categorize the inverter's characteristic data or performance parameters.

| **Current** | **Internal Temperature** | **Parameter** |
|---|---|---|
| 10% or min during 24h | min during 24 hour period | |
| 50% | 25 deg C | |
| 90% or max during 24h | max during 24h period | |

Based on the features of particular inverter (known based on manufacturer, model number, or other relevant inverter characteristics), typical data over time is logged and retrieved from the data server for similar equipment. Based on expired time and the actual parameter's first derivative, such as ESR, leakage current, cross-conduction percentage, and any additional component-specific performance parameter at day 1, day 2, etc., the remaining life of the inverter can be estimated by comparing it to existing units in the field and previously acquired data for units that have already failed. This enables retrofit applications of the predictive monitoring systems of the present disclosure, where the equipment to be monitored has already been in service for an extended period of time and may already be close to a failure.

After acquiring the performance baseline at step 504 to which all future performance data will be related, the method 500 continues at step 506 where raw data is acquired from all the high-speed ADCs. The data obtained is filtered and/or analyzed at step 508 by the DSP (430). The data is filtered by the DSP to only include data that passes a correlation test for input and output data, then the data is normalized to the initial baseline set of data obtained at step 504 and stored in the on-board non-volatile memory (NVRAM) at step 509. Generally, each performance data set is tagged by meta data, accurately describing the operational conditions of the inverter when the data was taken, allowing raw data to be corrected and compared to a default threshold limit at step 510. This meta data includes, but is not limited to, output RMS current, internal temperature, input DC voltage, and equipment identification such as serial number (date of manufacture), manufacturer brand, and model. Averaged data points for different operating conditions are then stored in NVRAM 442 and uploaded periodically (e.g., hourly, daily, weekly, or otherwise) via LAN to the Master Sensor.

Each dataset consists of a time series of voltage, current and temperature values, which has been reduced to a multitude of statistical metrics that have been calculated, such as peak, mean average, and first derivative calculations with time. A first derivate indicates a trend and the greater a change occurs in a given time period, the closer the device, whose parameter is being tracked, is approaching its wear-out limit. The first derivative can be described as a non-linear function with a multitude of input variables determining component performance. Prior art in Condition-Based Maintenance systems relies on modeling such function with a finite number of parameters. The present invention enables an active learning process, which uses pre-failure performance data, stored collectively at the central database, to indicate the statistical likelihood of a failure as a function of the derivative. For example, as capacitor ESR increases exponentially over time, normalized to the same operating conditions (temperature, average current, input voltage) as initially recorded as baseline data, the rate of change in ESR determines how close to an actual failure the component is, based on previously recorded failures with similar devices in the field. For example, the following data represents normalized ESR:

**Table 1: Exemplary Rate-of-Change analysis on capacitor ESR**

| **Day** | **ESR** | **Change** | **0.001** |
|---|---|---|---|
| **0** | **130.000** | **LIMIT 390** | |
| **1** | **130.130** | **0.100%** | |
| **10** | **131.306** | **0.101%** | |
| **20** | **132.625** | **0.101%** | |
| **100** | **143.665** | **0.106%** | |
| **200** | **158.766** | **0.116%** | |
| **300** | **175.455** | **0.128%** | |
| **400** | **193.898** | **0.142%** | |
| **500** | **214.280** | **0.157%** | |
| **600** | **236.804** | **0.173%** | |
| **700** | **261.696** | **0.191%** | |
| **800** | **289.205** | **0.212%** | |
| **900** | **319.605** | **0.234%** | |
| **1000** | **353.200** | **0.258%** | |
| **1010** | **356.748** | **0.273%** | |
| **1020** | **360.332** | **0.276%** | |
| **1030** | **363.951** | **0.278%** | |
| **1040** | **367.607** | **0.281%** | |
| **1050** | **371.300** | **0.284%** | |
| **1060** | **375.030** | **0.287%** | |
| **1070** | **378.797** | **0.290%** | |
| **1080** | **382,602** | **0.293%** | |
| **1090** | **386.445** | **0.296%** | |
| **1100** | **390.327** | **0.299%** | |

As shown in Table 1, Day 10 records a rate-of-change of 0.1% per day, exponentially growing into a near three-fold increase of the rate-of-change of 0.3% per day by Day 1,000. Based on similar device history, let's assume the average capacitor exceeded its wear-out limit by Day 1,100. In order to give an operator at least 90 day notice of an impending failure, a notification may be triggered when the rate of change exceeds 0.270% per day or 357 milli-Ohms, which indicates that its anticipate rate of change is greater than the average. Analysis of rate-of-change, also called "first derivative", can be equally applied to other component performance indicators that are accurate predictors such as, but not limited to, leakage current, cross-conduction, rise- and fall-times, response time, and signal propagation delay. Such analysis can be used on a variety of electronic components that are utilized in the inverter, such as power switches, including power MOSFETs, IGBTs, p-JFETs, controller boards, diodes, and other components.

Utilizing such an analysis, at step 512 it is determined whether the measured data exceeds the default threshold limits. If so, then the method continues to step 524 where it is determined whether there has been a device failure or not. If not, then the method continues to step 540 where the customer is alerted to the situation. Typically, the customer will be alerted via a remote terminal (such as remote terminal 146). If there has been a failure, then the method continues at step 526 where the unpredicted but detected failure will trigger an immediate cyclic memory freeze of the alert-issuing sensor node. With a high priority, an uncompressed data dump from the sensor to the error-handling application server will occur at step 528 and the data will be stored on the source ware house server for post analysis at step 530. Once a new algorithm has been developed and validated 532 with the previously saved pre-failure data, the data set describing the newly added failure mechanism may require expansion, and cause a global data-base broadcast at step 538 of a header update at step 536, sufficiently describing the new failure threat. The alerts are sent out to all similar units deployed in the field at step 538, notifying the operator and manufacturer about the increase failure risk level, which will allow them to take preventive action. Failures that are difficult to predict by typical wear-out patterns (e.g., failures related to a batch of under-performing components, such as a particular batch of resistors used in the manufacture of certain lot codes of inverters fail spontaneously) can be handled in this manner.

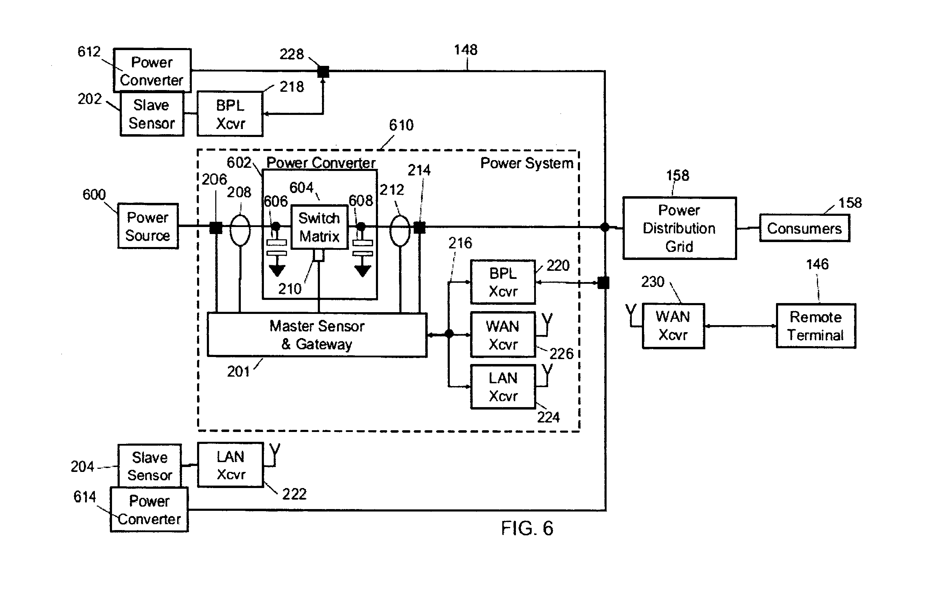

Returning again to step 512, if it is determined that the measured data is within the default threshold limits, then the master aggregates all data sets from each of the slaves, and compresses it at step 514 for upload and storage on the central server 324 (including source database 322 and/or customer database 320). The application server that is receiving data packets from the master, separates customer identity information and stores each device data on a time-series source ware house 322. At step 516 a post-processing software routine compares the derivative information with similar equipment datasets to derive at an improved estimated-time-to-failure ("ETTF"), stored under the customer database set. While actual performance data changes will be stored, the units will receive and update from any field failure data that is matching with the customer filter, machine type an by operator at step 518. The filter thereby can determine access rights by authority level granted by the administrator and only update new threat mechanisms and threshold levels relevant for the particular unit at step 520. After the updates, the method 500 will return to step 506 to continue the monitoring process with the updated algorithm and/or data. Referring now to FIG. 6, shown therein is a predictive monitoring system that is integrated with a power converter 602 into a power system 610, and its output is connected to other power converters 612, 614. Power source 600 is connected to the input of power converter 602 ("converter"). Input voltage fluctuations of the power source 600 are averaged across input capacitor 606 that stores energy of the power source and releases energy to the switch matrix 604 of the converter 602 to help with a continuous flow of current, which the power source may not be able to deliver at the rate the switch matrix is demanding. Similarly, output capacitor 608 also stores and releases energy that may operate at a different voltage level than the input, as sensed by voltage sensor 206. While such configuration is common to those practicing power converter design, it is also known that such capacitors have a limited operating life, and degrade over time, temperature, and voltage stress levels. The capacitor's equivalent series resistance has been commonly used as an indicator for its health, and its increase by a level of 200% from its original value deemed as a wear-out limit. Further degradation puts undue voltage stress on the switch matrix 604 attached to the input capacitor 606, and may lead to failure. Similarly, an increase in resistance also increases the heat generated internally to the capacitor, and accelerates the evaporation of the electrolyte, which further increases the resistance until the capacitor will destruct itself. More expensive film capacitors are sensitive to over-current and over-voltage stress, which may result from improper operation of the converter, high in-rush currents during start-up, or lightning induced discharges. As it is impractical to remove each capacitor for testing, the present invention enables in-situ measurement of capacitor ESR, during operation.

Power converters 612 and 614 illustrate embodiments that attach the predictive monitoring system physically to the outside of the power converter, whereas power system 610 depicts an integration of the predictive monitoring system into the power converter. With respect to power system 610, the predictive monitoring system can be reduced to practice in form of a system-on-chip ("SoC") as part of an electronic circuit board assembly, or, as an embedded component of the power converter controller design, which commonly use a digital signal processor or micro-processor for controlling the switch matrix and reporting functions. Without regard to the architecture and control method used for the switch, the present invention can be applied to any of the four conversion types: AC-to-DC, also known as active rectifier, DC-to -DC converter, DC-to-AC, also known as inverter, and AC-to-AC, also known as frequency converter. The latter often combines an AC-to-DC and a DC-to-AC power stage, with an optional means for energy storage between each power stage, such as batteries.

The smallest distributed renewable energy plant operates at least one solar panel 100, connected to a PV inverter ("micro-inverter") 110 that produces current output and is synchronized in amplitude and phase to the power distribution grid 154. While the systems, devices, and methods of the present disclosure may be employed using system-on-chip ("SoC") architecture, application-specific integrated circuit ("ASIC"), or embedded into an already existing digital signal processing ("DSP") circuit, the greatest economic benefits of the present disclosure are currently in the context of large commercial and utility-scale applications that utilize a large number of solar panels, connected in arrays of parallel configurations having a predetermined size of strings, each connected to a PV inverter sized according to the maximum expected power output capability of the array. Each inverter output is connected in parallel and combined at a step-up transformer (such as step-up transformer 150). In order to configure PV inverters in parallel, each inverter has to synchronize its current output to the power grid frequency and phase, so that grid voltage and frequency are maintained to the power utility specifications. Such inverters are commonly known as grid-tie inverters. One should appreciate the fact that the present invention enables the identification of a single degraded inverter in a network of coupled inverters, which outputs share the same voltage and frequency at the grid level.

In light of the foregoing description, the present disclosure provides a real-time data-acquisition system that extracts actual performance data during the operation of the unit, and compares its performance with historic performance, noting a change over time, or derivative performance information as its main decision criteria. While the best mode application is the prediction of photovoltaic inverter failure, any power conversion application employing power switches such as IGBTs, MOSFETs, capacitors, and fuses can be monitored with the disclosed system, including AC-AC conversion, DC-DC conversion, AC-DC conversion also known as active rectification, or DC-AC conversion.

Having thus described a preferred embodiment of a system and method of utilizing signal-processing to determine the substantial degradation of at least one internal component of a power converter circuit prior to it causing a system failure, it should be apparent to those skilled in the art that certain advantages of the system have been achieved. It should also be appreciated that various modifications, adaptations, and alternative embodiments thereof may be made within the scope of the claims.

## Claims

1. A method comprising:
monitoring input data associated with an input to a photovoltaic inverter;
monitoring output data associated with an output from the photovoltaic inverter;
analyzing the input data and the output data to identify trends predictive of failure of the photovoltaic inverter based on the input data and the output data, wherein analyzing the input and output data includes calculating derivatives of the input and output data.

2. The method of claim 1, wherein analyzing the input and output data is performed in substantially real-time.

3. The method of claim 2, wherein the input and output data that is analyzed comprises at least one of equivalent static resistance ("ESR"), leakage current, cross-conduction, rise-time, fall-time, response time, and signal propagation delay.

4. The method of claim 1, wherein monitoring the input data and monitoring the output data are performed by a slave sensor that is in communication with a master sensor.

5. The method of claim 4, wherein the analyzing is performed at least in part by the master sensor.

6. The method of claim 5, wherein the analyzing is performed at least in part by a server that is in communication with the master sensor.

7. The method of claim 5, wherein the analyzing is performed based on algorithms for identifying the trends received by the master sensor from a central server.

8. The method of claim 4, further comprising monitoring input data and output data associated with a plurality of photovoltaic inverters with a plurality of slave sensors, each of the slave sensors in communication with the master sensor.

9. A system comprising:
a first master sensor module in communication with a central server;
and
a plurality of slave sensors in communication with the master sensor, each of the slave sensors having at least an input current sensor and an output current sensor for monitoring input and output data associated with a photovoltaic inverter;
wherein the system is configured to analyze the input and output data associated with the photovoltaic inverter to identify trends predictive of failure of the photovoltaic inverter.

10. The system of claim 9, wherein the master sensor module receives updated algorithms for identifying the trends predictive of failure from the central server

11. The system of claim 9, further comprising a second master sensor module in communication with the plurality of slave sensors.

12. The system of claim 9, wherein at least one of the slave sensors further comprises an ambient temperature sensor for monitoring an ambient temperature adjacent the associated photovoltaic inverter and an internal temperature sensor for monitoring an internal temperature of the photovoltaic inverter.

13. The system of claim 9, wherein at least one processing unit analyzes the input data and the output data to identify the trends predictive of failure of the photovoltaic inverter based on the input data and the output data.

14. The system of claim 13, further comprising:
an input voltage protection circuit; and
an output voltage protection circuit;
the input and output voltage protection circuits each in communication with the at least one processing unit.

15. The system of claim 13, further comprising:
at least one high speed analog-to-digital converter and at least one low speed analog-to-digital converter positioned between the input current sensor and the at least one processing unit.

## Patentansprüche

1. Verfahren, umfassend:
das Überwachen von Eingabedaten, verbunden mit einer Eingabe in einen Photovoltaik-Inverter;
das Überwachen von Ausgabedaten, verbunden mit einer Ausgabe des Photovoltaik-Inverters;
das Analysieren der Eingabedaten und der Ausgabedaten zum Identifizieren von Trends zur Vorhersage von Defekten des Photovoltaik-Inverters basierend auf den Eingabedaten und den Ausgabedaten, wobei das Analysieren der Eingabe- und Ausgabedaten das Berechnen von abgeleiteten Werten der Eingabe- und Ausgabedaten umfasst.

2. Verfahren nach Anspruch 1, wobei das Analysieren der Eingabe- und Ausgabedaten im Wesentlichen in Echtzeit durchgeführt wird.

3. Verfahren nach Anspruch 2, wobei die analysierten Eingabe- und Ausgabedaten mindestens eine der folgenden Optionen enthalten:
äquivalenten statischen Widerstand ("ESR"), Leckstrom, Querleitung, Anstiegszeit, Abfallzeit, Reaktionszeit und Signallaufzeit.

4. Verfahren nach Anspruch 1, wobei das Überwachen der Eingabedaten und das Überwachen der Ausgabedaten durch einen Slave-Sensor, der in Kommunikation mit einem Master-Sensor steht, durchgeführt werden.

5. Verfahren nach Anspruch 4, wobei das Analysieren mindestens partiell vom Master-Sensor durchgeführt wird.

6. Verfahren nach Anspruch 5, wobei das Analysieren mindestens partiell von einem Server, der in Kommunikation mit dem Master-Sensor steht, durchgeführt wird.

7. Verfahren nach Anspruch 5, wobei das Analysieren basierend auf Algorithmen zum Identifizieren der durch den Master-Sensor von einem Zentralserver empfangenen Trends durchgeführt wird.

8. Verfahren nach Anspruch 4, ferner umfassend das Überwachen von Eingabedaten und Ausgabedaten, verbunden mit mehreren Photovoltaik-Invertern mit mehreren Slave-Sensoren, von denen jeder in Kommunikation mit dem Master-Sensor steht.

9. System, umfassend:
ein erstes Master-Sensor-Modul, in Kommunikation mit einem Zentralserver;
und
mehrere Slave-Sensoren, in Kommunikation mit dem Master-Sensor, wobei jeder der Slave-Sensoren mindestens einen Eingangsstromsensor und einen Ausgangsstromsensor zum Überwachen der Eingangs- und Ausgangsdaten, verbunden mit einem Photovoltaik-Inverter, hat;
wobei das System entsprechend konfiguriert ist, um die Eingangs- und Ausgangsdaten, verbunden mit dem Photovoltaik-Inverter, zu analysieren, um Trends zur Vorhersage von Defekten des Photovoltaik-Inverters zu identifizieren.

10. System nach Anspruch 9, wobei das Master-Sensor-Modul aktualisierte Algorithmen zum Identifizieren der Trends zur Vorhersage von Defekten vom Zentralserver empfängt.

11. System nach Anspruch 9, ferner umfassend ein zweites Master-Sensor-Modul, in Kommunikation mit den mehreren Slave-Sensoren.

12. System nach Anspruch 9, wobei mindestens einer der Slave-Sensoren ferner einen Umgebungstemperatursensor zum Überwachen einer Umgebungstemperatur, angrenzend an den verbundenen Photovoltaik-Inverter, und einen Innentemperatursensor zum Überwachen einer Innentemperatur des Photovoltaik-Inverters umfasst.

13. System nach Anspruch 9, wobei mindestens eine Verarbeitungseinheit die Eingangsdaten und die Ausgangsdaten analysiert, um die Trends zur Vorhersage von Defekten des Photovoltaik-Inverters basierend auf den Eingangsdaten und den Ausgangsdaten zu identifizieren.

14. System nach Anspruch 13, ferner umfassend:
einen Eingangsspannungsschutzkreis; und
einen Ausgangsspannungsschutzkreis;
wobei die Eingangs- und Ausgangsspannungsschutzkreise jeweils in Kommunikation mit der mindestens einen Verarbeitungseinheit stehen.

15. System nach Anspruch 13, ferner umfassend:
mindestens einen Analog-Digital-Hochgeschwindigkeitswandler und mindestens einen Analog-Digital-Niedergeschwindigkeitswandler, angeordnet zwischen dem Eingangsstromsensor und der mindestens einen Verarbeitungseinheit.

## Revendications

1. Procédé consistant à :
surveiller des données d'entrée associées à une entrée dans un onduleur photovoltaïque ;
surveiller des données de sortie associées à une sortie de l'onduleur photovoltaïque ;
analyser les données d'entrée et les données de sortie en vue d'identifier des tendances prédictives d'une défaillance de l'onduleur photovoltaïque, sur la base des données d'entrée et des données de sortie, dans lequel l'analyse des données d'entrée et des données de sortie consiste à calculer des dérivés des données d'entrée et des données de sortie.

2. Procédé selon la revendication 1, dans lequel l'analyse des données d'entrée et des données de sortie est mise en oeuvre sensiblement en temps réel.

3. Procédé selon la revendication 2, dans lequel les données d'entrée et les données de sortie qui sont analysées comportent au moins l'une des caractéristiques parmi une résistance statique équivalente (« ESR »), un courant de fuite, une conduction croisée, un temps de montée, un temps de descente, un temps de réponse, et un retard de propagation de signal.

4. Procédé selon la revendication 1, dans lequel la surveillance des données d'entrée et la surveillance des données de sortie sont mises en oeuvre par un capteur esclave qui est en communication avec un capteur maître.

5. Procédé selon la revendication 4, dans lequel l'analyse est mise en oeuvre au moins en partie par le capteur maître.

6. Procédé selon la revendication 5, dans lequel l'analyse est mise en oeuvre au moins en partie par un serveur qui est en communication avec le capteur maître.

7. Procédé selon la revendication 5, dans lequel l'analyse est mise en oeuvre sur la base d'algorithmes destinés à identifier les tendances reçues par le capteur maître à partir d'un serveur central.

8. Procédé selon la revendication 4, consistant en outre à surveiller des données d'entrée et des données de sortie associées à une pluralité d'onduleurs photovoltaïques, au moyen d'une pluralité de capteurs esclaves, chacun des capteurs esclaves étant en communication avec le capteur maître.

9. Système comprenant :
un premier module de capteur maître en communication avec un serveur central ; et
une pluralité de capteurs esclaves en communication avec le capteur maître, chacun des capteurs esclaves présentant au moins un capteur de courant d'entrée et un capteur de courant de sortie destinés à surveiller des données d'entrée et des données de sortie associées à un onduleur photovoltaïque ;
dans lequel le système est configuré de manière à analyser les données d'entrée et les données de sortie associées à l'onduleur photovoltaïque, en vue d'identifier des tendances prédictives d'une défaillance de l'onduleur photovoltaïque.

10. Système selon la revendication 9, dans lequel le module de capteur maître reçoit des algorithmes mis à jour en vue d'identifier les tendances prédictives d'une défaillance à partir du serveur central.

11. Système selon la revendication 9, comprenant en outre un second module de capteur maître en communication avec la pluralité de capteurs esclaves.

12. Système selon la revendication 9, dans lequel au moins l'un des capteurs esclaves comprend en outre un capteur de température ambiante destiné à surveiller une température ambiante au voisinage de l'onduleur photovoltaïque associé, et un capteur de température interne destiné à surveiller la température interne de l'onduleur photovoltaïque.

13. Système selon la revendication 9, dans lequel au moins une unité de traitement analyse les données d'entrée et les données de sortie en vue d'identifier les tendances prédictives d'une défaillance de l'onduleur photovoltaïque sur la base des données d'entrée et des données de sortie.

14. Système selon la revendication 13, comprenant en outre :
un circuit de protection de tension d'entrée ; et
un circuit de protection de tension de sortie ;
les circuits de protection de tension d'entrée et de sortie étant chacun en communication avec ladite au moins une unité de traitement.

15. Système selon la revendication 13, comprenant en outre :
au moins un convertisseur analogique à numérique à haute vitesse et au moins un convertisseur analogique à numérique à faible vitesse positionnés entre le capteur de courant d'entrée et ladite au moins une unité de traitement.
